# EUROPÄISCHE PATENTANMELDUNG

(11) **EP 4 050 235 A1**
(43) Veröffentlichungstag der Anmeldung: **31.08.2022**
(21) Anmeldenummer: 21159694.5
(22) Anmeldetag: 26.02.2021
(51) Int. Cl.: F16H 1/46, F16H 57/04, F03D 80/70, F16H 1/28, F16H 57/08

(54) **PLANETENGETRIEBE MIT VERBESSERTER SCHMIERSTOFFVERSORGUNG, ANTRIEBSSTRANG UND WINDKRAFTANLAGE**

(71) Anmelder: Flender GmbH, 46395 Bocholt (DE)
(72) Erfinder: Haake, Norbert, 46282 Dorsten (DE)
(74) Vertreter: Michalski Hüttermann & Partner Patentanwälte mbB

(57) **Zusammenfassung**

Die Erfindung betrifft ein Planetengetriebe (10), das eine erste und eine zweite Planetenstufe (20, 30), zumindest eine Getriebekomponente (11) und ein doppelwandiges Rohr (60) umfasst. Daran ist in einem mittleren Abschnitt (50) eine Auslassstelle (63) zum Abgeben von Schmierstoff (35) in die Getriebekomponente (11) ausgebildet. Das doppelwandige Rohr 60 ist in einem Führungslager (45) aufgenommen ist, wobei im Bereich der Auslassstelle (63) eine Buchse (66) angeordnet ist. Erfindungsgemäß ist zwischen der Buchse (66) und der Getriebekomponente (11) ein Spalt (80) ausgebildet. Die Erfindung betrifft auch einen Antriebsstrang (81) mit einem Generator (86), der mit einem Getriebe (84) verbunden ist, das als erfindungsgemäßes Planetengetriebe (10) ausgebildet ist. Ebenso betrifft die Erfindung eine Windkraftanlage (90), die über einen solchen Antriebsstrang (81) verfügt. Ferner betrifft die Erfindung ein Computerprogrammprodukt (70), mit dem das Betriebsverhalten eines solchen Planetengetriebes (10) simulierbar ist.

## Beschreibung

Die Erfindung betrifft ein Planetengetriebe, das über eine verbesserte Schmierstoffversorgung verfügt. Die Erfindung betrifft ebenso einen Antriebsstrang, der über ein entsprechendes Planetengetriebe verfügt und eine Windkraftanlage, die mit einem solchen Antriebsstrang ausgestattet ist.

Die bisher unveröffentlichte Europäische Patentanmeldung mit der Anmeldungsnummer 19200060.2-1012 zeigt ein Planetengetriebe mit verbesserter Schmierstoffversorgung. Das Planetengetriebe umfasst zwei Planetenstufen und ein doppelwandiges Rohr, das im Wesentlichen aus einem inneren und einem äußeren Rohr zusammengesetzt ist. An einer Auslassstelle ist eine Buchse angeordnet. Zwischen der Buchse und dem doppelwandigen Rohr ist dabei ein Spalt ausgebildet.

Aus EP 2 597 307 A1 ist eine Vorrichtung zur Übertragung von Versorgungsmitteln durch einen Antriebsstrang einer Windkraftanlage bekannt, die ein doppelwandiges Durchführungsrohr umfasst, das ein inneres und ein äußeres Rohr umfasst. Das innere und das äußere Rohr bilden einen Ringkanal für Schmieröl aus. Das innere und das äußere Rohr sind auf Endstücke aufgeschoben, durch die zwischen dem äußeren und dem inneren Rohr ein Wandabstand eingestellt wird.

Die Druckschrift DE 10 2010 060 147 A1 offenbart ein Planetengetriebe mit einem Zentralverteiler, der als Ringkanal ausgeführt ist. Über eine abtriebsseitig angeordnete Einlassstelle wird Schmierstoff zugeführt, der an einer weiter antriebsseitig platzierten Auslassstelle einer Planetenstufe zugeführt wird. An der Auslassstelle sind Dichtungen aus PTFE positioniert, die in Kontakt mit dem Zentralverteiler stehen.

Die Internationale Anmeldung WO 2020/001942 A1 offenbart ein Planetengetriebe, das über drei hintereinander geschaltete Planetenstufen verfügt. Die Planetenstufen können dabei mit mindestens vier, fünf, oder auch bis zu zehn Planetenrädern ausgestattet sein.

Planetengetriebe werden in einer Vielzahl an technischen Gebieten eingesetzt, in denen steigende Anforderungen in puncto Leistungsfähigkeit, Zuverlässigkeit, Lebensdauer und Wirtschaftlichkeit gestellt werden. Ferner wird unter anderem eine effiziente Nutzung von Schmierstoffen angestrebt. Dies gilt insbesondere für Planetengetriebe in Windkraftanlagen. Der vorliegenden Erfindung liegt die Aufgabe zugrunde, ein Planetengetriebe bereitzustellen, das in zumindest einem der skizzierten Aspekte eine technische Verbesserung bietet.

Die Aufgabenstellung wird durch ein erfindungsgemäßes Planetengetriebe gelöst. Das Planetengetriebe weist zumindest eine erste und eine zweite Planetenstufe auf, die hintereinandergeschaltet sind. Das Planetengetriebe weist auch ein doppelwandiges Rohr auf, das in einem Bereich einer Hauptdrehachse des Planetengetriebes angebracht ist. Das doppelwandige Rohr umfasst ein inneres Rohr und ein äußeres Rohr, durch die ein Ringkanal für einen Schmierstoff gebildet wird. Das innere Rohr kann beispielsweise als Pitchrohr ausgebildet sein, durch das Leitungen durch das Planetengetriebe führbar sind. Das doppelwandige Rohr weist, entlang der Hauptdrehsachse betrachtet, in einem mittleren Abschnitt eine Auslassstelle auf, die zu einem Abgeben von Schmierstoff aus dem doppelwandigen Rohr in eine Getriebekomponente ausgebildet ist. Dazu ist an der Auslassstelle eine Buchse angeordnet. Der Schmierstoff passiert bei einem Abgeben an die Getriebekomponente somit die Buchse. Durch die Buchse wird eine leckagearme, nahezu leckagefreie, Übergabe des Schmierstoffs an die Getriebekomponente ermöglicht. Eine Buchse ist hierbei besonders langlebig, leckagehemmend und wirtschaftlich herstellbar. Dadurch wird ein erhöhter Durchsatz an Schmierstoff ermöglicht, der beispielsweise durch erhöhten Förderdruck im Schmierstoff gewährleistet werden kann. Infolge der leckagehemmenden Wirkung der Buchse ist ein so eintretender Schmierstoffverlust minimiert, und somit noch technisch akzeptabel. Infolgedessen kann für Getriebekomponenten, beispielsweise für Gleitlager von Planetenrädern oder Sprühschmierungen von Verzahnungen, so eine verbesserte Schmierung und/oder Kühlung erzielt werden. Dies erlaubt wiederum, das Planetengetriebe einer erhöhten Betriebslast zu unterwerfen. Die erfindungsgemäße Buchse dient damit zu einer Leistungssteigerung des erfindungsgemäßen Planetengetriebes. Die Buchse selbst kann relativ geringe Abmessungen aufweisen und somit einen sparsamen Einsatz von entsprechend geeigneten Werkstoffen wie beispielsweise Bronze erlauben, aus denen die Buchse hergestellt sein kann. Alternativ kann die Buchse auch aus einem Nicht-Gleitwerkstoff hergestellt sein, beispielsweise einer Stahllegierung, Gusseisen, Aluminium, einer Aluminiumlegierung oder einem Faserverbundwerkstoff wie glasfaserverstärktem Kunststoff, kohlefaserverstärktem Kunststoff, aramidfaserverstärktem Kunststoff, oder einer Kombination hieraus.

Darüber hinaus weist das Planetengetriebe im Bereich der Auslassstelle im mittleren Abschnitt ein Führungslager auf, das zu einem Einstellen eines Spalts an der Buchse ausgebildet ist. Das Führungslager, das beispielweise als Wälzlager ausgebildet sein kann, ist derart positioniert, dass es sich gegen die Getriebekomponente abstützt, in die durch die Auslassstelle Schmierstoff abzugeben ist. Dazu kann das Führungslager benachbart zur Buchse positioniert sein. Insbesondere können die Buchse und das Führungslager im Bereich einer Innenseite einer Nabe eines Planetenträgers der zweiten Planetenstufe angeordnet sein. Derartige Führungslager sind in einer Vielzahl an Größen einfach verfügbar und bieten ein hohes Maß an Ausrichtungspräzision für das doppelwandige Rohr, insbesondere für dessen äußeres Rohr. Gleichzeitig erlaubt ein solches Führungslager, bezogen auf die Hauptdrehachse, eine relative Drehung zwischen dem doppelwandigen Rohr und der entsprechenden Getriebekomponente. Bei einer erhöhten Beanspruchung des Planetengetriebes können im Bereich des mittleren Abschnitts des doppelwandigen Rohres Biegebeanspruchungen auftreten. Dadurch kann der Spalt an der Buchse gestört, werden. Insbesondere kann der Spalt auf einer Seite radial verengt und auf einer entgegengesetzten Seite radial geweitet werden, was wiederum zu erhöhtem Schmierstoffverlust führt. Je näher das Führungslager axial an der Buchse angeordnet ist, umso stärker können Verlagerungen, beispielsweise Axialversätze oder Radialversätze, die zu einer Störung des Spalts führen, vermieden werden. Dies erlaubt es, in einfacher Weise die Belastbarkeit des beanspruchten Planetengetriebes zu steigern.

Erfindungsgemäß ist der Spalt an der Auslassstelle zwischen der Buchse und der Getriebekomponente ausgebildet. Im bestimmungsgemäßen Betrieb tritt Schmierstoff in den Spalt ein, so dass zwischen der Getriebekomponente und der Buchse keine unmittelbare Berührung vorliegt. Der Spalt weist eine minimierte Spalthöhe, also eine radiale Abmessung, auf. Durch die minimierte Spalthöhe wird ein Schmierstoffverlust am Spalt verringert. Dadurch, dass die Buchse einen relativ geringen Außendurchmesser aufweist, stehen die Toleranzen, die zur Erzielung eines minimierten Spalts einzuhalten sind, in einem günstigeren Verhältnis zu den Gesamtabmessungen, insbesondere zum Außendurchmesser der Buchse. Dies erlaubt eine kosteneffiziente Herstellung der Buchse. Ferner ist so eine Relativbewegung zwischen der Getriebekomponente und der Buchse in eine Axialrichtung ausgleichbar.

In einer Ausführungsform des beanspruchten Planetengetriebes kann der Spalt an einer Außenfläche der Buchse ausgebildet sein. Infolgedessen ist die Buchse drehfest mit dem doppelwandigen Rohr, insbesondere dessen innerem Rohr, verbunden sein. Eine Montage der Buchse wird dadurch vereinfacht. Insbesondere ist eine Montage vermeidbar, in der die Buchse an ihrer Außenfläche über eine Presspassung eingebaut wird. Infolgedessen wird die Wartungs- und Reparaturfreundlichkeit des beanspruchten Planetengetriebes gesteigert.

Darüber hinaus kann am äußeren Rohr des doppelwandigen Rohrs eine Lagerbuchse angeordnet sein. Die Lagerbuchse umgibt das doppelwandige Rohr und weist eine im Wesentlichen radial ausgerichtete Öffnung aus, die einen Durchlass des Schmierstoffs erlaubt. Die Lagerbuchse kann drehfest mit dem doppelwandigen Rohr verbunden sein und so die drehfeste Verbindung der Buchse mit dem doppelwandigen Rohr verwirklichen. Die Lagerbuchse ist insbesondere in puncto Radialabmessungen in einfacher Weise konstruktiv anpassbar. Infolgedessen ist die Buchse materialsparend auslegbar. Durch die Lagerbuchse ist ein Radialabstand zwischen dem doppelwandigen Rohr und der Getriebekomponente, in die der Schmierstoff aus der Auslassstelle abzugeben ist, zumindest teilweise überbrückbar. Dementsprechend kann die Verwendung kostenintensiver Materialien wie Bronze für die Buchse minimiert werden. Die Lagerbuchse kann lösbar, also im Wesentlichen zerstörungsfrei lösbar, ausgebildet sein. Dies erlaubt es, die Lagerbuchse in einfacher Weise mit erhöhter Präzision zu fertigen. Darüber hinaus kann die Lagerbuchse axial beweglich ausgebildet sein, so dass im Betrieb des Planetengetriebes beispielsweise ein Axialversatz des doppelwandigen Rohrs ausgleichbar ist.

Ferner kann die Lagerbuchse in einem Innenring des Führungslagers aufgenommen sein. Korrespondierend kann ein Außenring des Führungslagers an der Getriebekomponente angeordnet sein, in die der Schmierstoff aus der Auslassstelle abzugeben ist. Die Lagerbuchse ist in einem Bereich, in dem der Innenring des Führungslagers angeordnet ist, in Radialrichtung in einfacher Weise anpassbar. Eine Radialposition der Buchse ist infolgedessen unabhängig von den Abmessungen des Führungslagers wählbar. Die Lagerbuchse ist im Zusammenwirken mit der Getriebekomponente folglich an die Abmessungen eines vorhandenen Führungslagers anpassbar. Das Führungslager kann deshalb als Normteil aus einer Normteilreihe ausgebildet sein, die fest vorgegebene Größensprünge aufweist. Als Führungslager kann dadurch ein kosteneffizientes Normteil eingesetzt werden und gleichzeitig die Buchse unabhängig davon an die Erfordernisse des Spalts zwischen der Buchse und der Getriebekomponente ausgelegt werden. Hierdurch wird eine gesteigerte Dichtwirkung am Spalt und gleichzeitig eine erhöhte Kosteneffizienz erzielt. Darüber hinaus kann das Führungslager an der Getriebekomponente lösbar befestigt sein, beispielsweise über einen Haltering. Ein Einschrumpfen oder Kleben des Führungslagers ist hierdurch entbehrlich, was eine vereinfachte Montage und Wartung erlaubt. Des Weiteren ist das doppelwandige Rohr im Wesentlichen unabhängig von der Größe des Führungslagers auswählbar. Gegenüber Lösungen aus den Stand der Technik ist die Dimensionierung des doppelwandiges Rohres nicht durch die Größen und Größensprünge bestimmt, in denen das Führungslager verfügbar ist.

In einer weiteren Ausführungsform des beanspruchten Planetengetriebes kann die Buchse auf der Lagerbuchse angebracht sein, also im Wesentlichen an deren Außenfläche. Dabei kann die Buchse auf der Lagerbuchse beispielsweise durch Aufschrumpfen angebracht sein. Eine solche Verbindung zwischen der Buchse und der Lagerbuchse bietet zwischen diesen eine gesteigerte Dichtwirkung. Ebenso können Abweichungen in der Rundheit der Lagerbuchse, insbesondere an deren Außenfläche, so zumindest teilweise ausgeglichen werden. Dabei ist die Buchse mit demontierbar und die Lagerbuchse zusammen mit der Buchse durch ein Ersatzteil im Wesentlichen modular austauschbar.

Des Weiteren kann die Getriebekomponente eine Gegenbuchse umfassen, die die Buchse im Wesentlichen umgibt. Der Spalt an der Buchse ist dadurch zwischen dieser und der Gegenbuchse ausgebildet. Des Weiteren kann das Führungslager, insbesondere dessen Außenring, in der Gegenbuchse aufgenommen sein. Die Lagerbuchse, die Buchse und die Gegenbuchse sind so separat aufeinander anpassbar und bilden zusammen ein Schmierstoffübergabemodul. Dies erlaubt eine präzise und gleichzeitig kosteneffiziente Fertigung. Insbesondere können die Buchse und/oder die Gegenbuchse gezielt im Bereich des Spalts mit erhöhter Präzision gefertigt werden. Für andere Bereiche können breitere Toleranzen gewählt werden, die noch eine hinreichende Montierbarkeit bieten. Aufwendige Oberflächenbearbeitungen, durch die am Spalt ein Schmierstoffverlust minimierbar ist, sind dort lokal begrenzt durchführbar, und so kosteneffizient. Das Prinzip der bedarfsgerechten Fertigung wird dadurch weiter verwirklicht. Das Schmierstoffübergabemodul ist als Ganzes, also modular, montierbar. Die Herstellung und Wartung des beanspruchten Planetengetriebes werden so weiter vereinfacht. Ferner ist durch eine solche Gegenbuchse eine vereinfachte Schmierstoffführung erreichbar und die Herstellung des beanspruchten Planetengetriebes weiter vereinfacht.

Ferner kann das beanspruchte Planetengetriebe in der ersten Planetenstufe zumindest fünf Planetenräder, bevorzugt fünf bis zwölf, weiter bevorzugt sieben bis zehn Planetenräder, aufweisen. Alternativ oder ergänzend kann die zweite Planetenstufe zumindest vier Planetenräder, bevorzugt sechs oder sieben Planetenräder, aufweisen. Je mehr Planetenräder in einem Planetenträger einer Planetenstufe angeordnet sind, umso mehr Schmierstoff ist in der entsprechenden Planetenstufe notwendig. Die Verwendung einer erfindungsgemäßen Buchse erlaubt es, bei erhöhtem Durchsatz von Schmierstoff die Schmierstoffverluste zu minimieren. Insbesondere kann dadurch eine Steigerung des Durchsatzes an Schmierstoff erzeugt werden, ohne den Förderdruck oder das gesamte Schmierstofffördervolumen zu erhöhen. Der Förderdruck ist im Wesentlichen dadurch begrenzt, dass durch zu hohen Förderdruck beispielsweise an Flachstrahldüsen Schaumbildung auftreten kann. Das Schmierstofffördervolumen wird im Wesentlichen von der Fördermenge einer Schmierstoffpumpe begrenzt. Das Planetengetriebe kann folglich leistungsgesteigert mit einer erhöhten Anzahl an Planetenrädern in den Planetenstufen ausgebildet sei. Entsprechende Planetengetriebe sind in der Europäischen Patentanmeldung EP 3 587 863 A1 offenbart, deren Offenbarungsgehalt durch Verweisung in die vorliegende Anmeldung mit einbezogen wird.

Des Weiteren kann die zweite Planetenstufe, in deren Bereich die Auslassstelle im mittleren Bereich des doppelwandigen Rohrs ausgebildet ist, zwischen der ersten Planetenstufe und einer dritten Planetenstufe angeordnet sein. Die beanspruchte Lösung erlaubt es, eine zuverlässige, leckagearme und gleichzeitig leistungsfähige Schmierstoffversorgung für Planetenstufen bereitzustellen, die in einem axial inneren Bereich eines Planetengetriebes angeordnet sind. Dadurch, dass eine Buchse eingesetzt wird, zwischen der und der Getriebekomponente keine unmittelbare Berührung vorliegt, liegt auch kein technisch relevanter Verschleiß vor, der häufige Inspektionen der Auslassstelle erfordert. Das beanspruchte Planetengetriebe kann deshalb drei oder mehr Planetenstufen oder weitere Stirnradstufen aufweisen, durch die die zweite oder auch weiter innenliegende Planetenstufe nur aufwendig zugänglich ist. Hierdurch werden komplexe Planetengetriebe mit einer erhöhten Anzahl an Planetenstufen technisch praktikabel herstellbar und wirtschaftlich betreibbar.

In einer weiteren Ausführungsform des beanspruchten Planetengetriebes kann die Getriebekomponente, an die der Schmierstoff abzugeben ist, ein Planetenträger sein, beispielsweise ein Planetenträger der zweiten Planetenstufe. Zwischen einem Planetenträger und einem doppelwandigen Rohr, das beispielsweise als Pitch-Rohr dient, kann im Betrieb des Planetengetriebes eine Relativdrehung vorliegen. Durch die erfindungsgemäße Buchse ist Schmierstoff zumindest leckagearm übertragbar, was eine effiziente Schmierstoffversorgung von Planetenradlagern, beispielsweise Gleitlager, oder Planetenträgerlagern erlaubt, die auch als Schmierstoffverbraucher bezeichnet werden. Der Planetenträger kann eine Mehrzahl an Bohrungen aufweisen, die ein im Wesentlichen verlustfreies Transportieren des Schmierstoffs zu den entsprechenden Schmierstoffverbrauchern ermöglicht. Alternativ kann die Getriebekomponente auch ein Sonnenrad des Planetengetriebes sein, und so beispielsweise einen Verzahnungseingriff zwischen dem Sonnenrad und den damit kämmenden Planetenrädern mit Schmierstoff zu versorgen. Je höher der Außendurchmessers des Sonnenrads ist, umso stärker treten die skizzierten technischen Vorzüge hervor. Folglich ist im beanspruchten Planetengetriebe auch eine Vielzahl von Schmierstoffverbrauchern, und damit in einem komplexen Schmierstoffsystem, zuverlässig mit Schmierstoff versorgbar.

Darüber hinaus kann im beanspruchten Planetengetriebe im Bereich eines ersten Endes des doppelwandigen Rohrs eine Auslassstelle ausgebildet sein. Die Auslassstelle am ersten Ende des doppelwandigen Rohrs ist dazu ausgebildet, die erste Planetenstufe mit Schmierstoff zu versorgen, beispielsweise Planetenradlager, die als Gleitlagern oder Wälzlagern im Planetenträger ausgebildet sein können, Verzahnungen in der ersten Planetenstufe, und/oder Lager, in denen der Planetenträger gelagert ist, also Planetenträgerlager. Das äußere und/oder das innere Rohr des doppelwandigen Rohrs können dazu drehfest mit dem Planetenträger der ersten Planetenstufe verbunden sein. Alternativ kann das doppelwandige Rohr auch drehfest jeglicher anderen drehenden oder stationären Getriebekomponente befestigt sein. Weiter alternativ kann das doppelwandige Rohr auch lose im Planetengetriebe drehbar ausgebildet sein. Infolgedessen liegen zwischen dem Planetenträger der ersten Planetenstufe und dem doppelwandigen Rohr keine relative Drehung vor. Dementsprechend kann die Auslassstelle am ersten Ende über zumindeste einen Nutring abgedichtet werden. Nutringe üben lediglich reduzierte Rückstellkräfte in Axialrichtung und Radialrichtung aus, so dass das Führungslager im Betrieb nur reduzierten mechanischen Beanspruchungen unterworfen ist. Die so ausgeübten reduzierten Rückstellkräfte sind durch eine Gewichtskraft einer Getriebekomponente hervorrufbar und wirken im beanspruchten Planetengetriebe im Wesentlichen kontinuierlich. Dadurch ist für ein Wälzlager eine Mindestlast bereitstellbar. Dies wiederum erlaubt ebenso die Verwendung einfacher Führungslager mit reduzierter Tragfähigkeit. Der zumindest eine Nutring dient folglich zu einer Reduzierung einer Axialbeanspruchung des Führungslagers und/oder zu einer Erhöhung der nutzbaren Lebensdauer des Führungslagers.

Darüber hinaus kann an einem zweiten Ende des doppelwandigen Rohrs eine Zulaufbuchse angeordnet sein. Das zweite Ende kann dabei an einem der ersten Planetenstufe abgewandten Ende des doppelwandigen Rohrs liegen. Durch die Zulaufbuchse erfolgt ein Zufluss an Schmierstoff, der über die Auslassstellen in mittleren Abschnitt gegebenenfalls am ersten Ende dem Planetengetriebe zugeführt wird. Die Zulaufbuchse kann dabei gemäß einer der Ausführungsformen der Buchse an der Auslassstelle im mittleren Abschnitt ausgebildet sein. Die Zulaufbuchse ist zwischen dem äußeren Rohr und einer Gehäusewandung des Planetengetriebes angeordnet, wobei in der Gehäusewandung eine Zulaufbohrung für den Schmierstoff ausgebildet ist. Insbesondere kann zwischen der Zulaufbuchse und dem doppelwandigen Rohr ein Spalt ausgebildet sein. Dementsprechend wird so eine zuverlässige und leckagearme Zufuhr von Schmierstoff für das doppelwandige Rohr verwirklicht.

Die zugrundeliegende Aufgabenstellung wird auch durch den erfindungsgemäßen Antriebsstrang gelöst. Der Antriebsstrang umfasst eine Hauptwelle, die mit einem Mehrblattrotor einer Windkraftanlage verbindbar ist. Die Hauptwelle ist drehmomentübertragend mit einem Getriebe gekoppelt, das wiederum drehmomentübertragend mit einem Generator verbunden ist. Dadurch ist eine Drehung des Mehrblattrotors in eine Drehung des Generators umsetzbar und Elektrizität erzeugbar. Der Antriebsstrang ist dazu ausgebildet, in einer Gondel einer Windkraftanlage aufgenommen zu werden. Erfindungsgemäß ist das Getriebe im Antriebsstrang als Planetengetriebe gemäß zumindest einer der oben skizzierten Ausführungsformen ausgebildet.

Gleichermaßen wird die Aufgabenstellung, von der die Erfindung ausgeht, durch die erfindungsgemäße Windkraftanlage gelöst. Die Windkraftanlage weist eine Gondel auf, an der ein Mehrblattrotor drehbar befestigt ist. In der Gondel ist ein Antriebsstrang aufgenommen, der mit dem Mehrblattrotor drehmomentübertragend verbunden ist. Der Antriebsstrang ist dabei gemäß einer der oben dargestellten Ausführungsformen ausgebildet.

Ebenso wird die beschriebene Aufgabe durch ein erfindungsgemäßes Computerprogrammprodukt gelöst, das zu einem Simulieren eines Betriebsverhaltens eines Planetengetriebes ausgebildet ist, also dazu eingerichtet ist. Das zu simulierende Planetengetriebe ist erfindungsgemäß nach einer der oben beschriebenen Ausführungsformen ausgebildet. Das Computerprogrammprodukt kann zur Simulation über ein Physik-Modul verfügen, in dem das Planetengetriebe abgebildet ist und beispielsweise dessen mechanisches oder thermisches Verhalten unter einstellbaren Betriebsbedingungen nachstellbar ist. Beispielsweise gehören zu den einstellbaren Betriebsbedingungen eine Drehzahl, eine Schmierstofftemperatur, ein Druck im Schmierstoff, oder dessen thermisches Verhalten, wie unter anderem eine temperaturabhängiger Viskositätscharakteristik, und/oder eine axiale Verlagerung und/oder radiale Verlagerung eines doppelwandigen Rohrs. Hierzu kann das Computerprogrammprodukt über eine Datenschnittstelle verfügen, über die entsprechende Daten über eine Benutzereingabe und/oder andere simulationsgerichtete Computerprogrammprodukte vorgebbar sind. Das Computerprogrammprodukt kann auch über eine Datenschnittstelle zum Ausgeben von Simulationsresultaten an einen Benutzer und/oder andere simulationsgerichtete Computerprogrammprodukte verfügen. Mittels des Computerprogrammprodukts sind beispielsweise Messdaten von Sensoren am Planetengetriebe, einem zugehörigen Antriebsstrang, oder an einer Windkraftanlage auf Plausibilität prüfbar. Dadurch kann unter anderem ein defekter Sensor identifiziert werden. Das Computerprogrammprodukt kann als sogenannter Digitaler Zwilling ausgebildet sein, wie beispielsweise in der Druckschrift US 2017/286572 A1 näher beschrieben. Der Offenbarungsgehalt von US 2017/286572 A1 wird durch Verweisung in die vorliegende Anmeldung mit einbezogen. Das Computerprogrammprodukt kann monolithisch ausgebildet sein, also vollständig auf einer Hardwareplattform ausführbar. Alternativ kann das Computerprogrammprodukt modular ausgebildet sein und eine Mehrzahl an Teilprogrammen umfassen, die auf separaten Hardwareplattformen ausführbar sind und über eine kommunikative Datenverbindung zusammenwirken. Eine solche kommunikative Datenverbindung kann eine Netzwerkverbindung oder eine Internetverbindung sein. Insbesondere kann das Computerprogrammprodukt in einer Computer-Cloud ausführbar ausgebildet sein. Ferner ist durch das erfindungsgemäße Computerprogrammprodukt eine Planetenträgeranordnung per Simulation erprobt und/oder optimiert werden.

Die Erfindung wird im Folgenden anhand einzelner Ausführungsformen in Figuren näher erläutert. Die Figuren sind insoweit in gegenseitiger Ergänzung zu lesen, dass gleiche Bezugszeichen in unterschiedlichen Figuren die gleiche technische Bedeutung haben. Die Merkmale der einzelnen Ausführungsformen sind untereinander auch kombinierbar. Ferner sind die in den Figuren gezeigten Ausführungsformen mit den oben skizzierten Merkmalen kombinierbar. Es zeigen im Einzelnen:
- FIG 1: schematisch eine erste Ausführungsform des beanspruchten Planetengetriebes im Längsschnitt;
- FIG 2: eine Detailansicht der ersten Ausführungsform des beanspruchten Planetengetriebes im Längsschnitt;
- FIG 3: eine Detailansicht einer zweiten Ausführungsform des beanspruchten Planetengetriebes im Längsschnitt;
- FIG 4: eine Detailansicht einer dritten Ausführungsform des beanspruchten Planetengetriebes im Längsschnitt;
- FIG 5: schematisch den Aufbau einer Ausführungsform der beanspruchten Windkraftanlage in einer geschnittenen Schrägansicht.

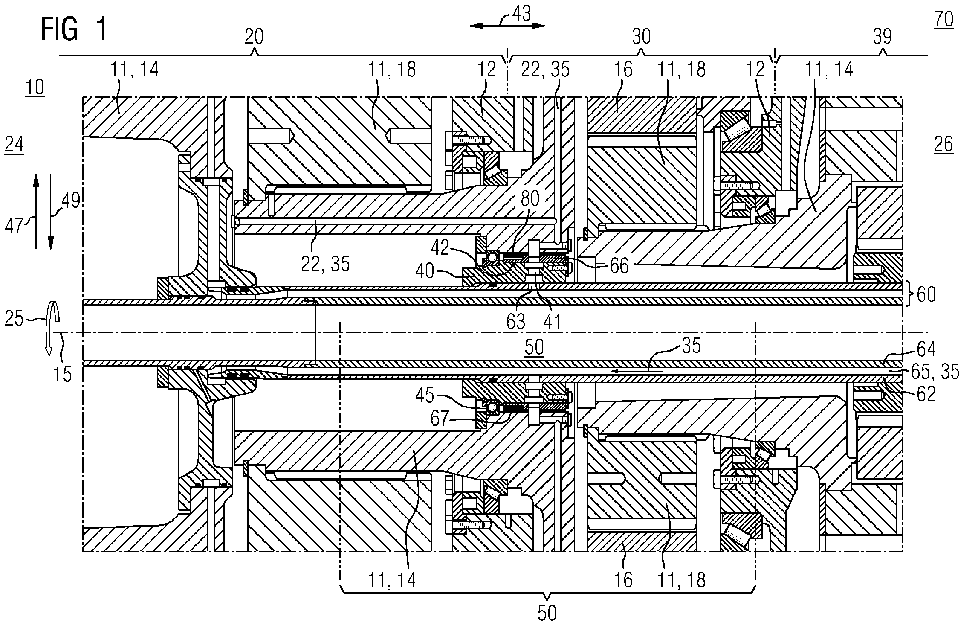

Eine erste Ausführungsform des beanspruchten Planetengetriebes 10 ist in FIG 1 im Längsschnitt dargestellt. Das Planetengetriebe 10 ist dazu ausgebildet, durch Drehung um eine Hauptdrehachse 15 eine Antriebsleistung 25 von einer Antriebsseite 24 zu einer Abtriebsseite 26 zu transportieren. Das Planetengetriebe 10 umfasst dazu eine erste Planetenstufe 20 und eine zweite Planetenstufe 30, die entlang einer Axialrichtung 43 hintereinandergeschaltet angeordnet sind. Daran schließt sich eine nicht näher gezeigte dritte Planetenstufe 39 an. Sowohl die erste als auch die zweite Planetenstufe 20, 30 weisen jeweils Getriebekomponenten 11 auf, die in einem Gehäuse 12 aufgenommen sind. Zu den Getriebekomponenten 11 gehören Planetenträger 14, in denen jeweils Planetenräder drehbar aufgenommen sind, die je Planetenstufe 20, 30 mit einem Sonnenrad 18 zusammenwirken. Das Sonnenrad 18 in der ersten Planetenstufe 20 ist mit dem Planetenträger 14 der zweiten Planetenstufe 30 verbunden. Ferner gehört zu den Getriebekomponenten 11 auch je Planetenstufe 20, 30 ein nicht näher gezeigtes Hohlrad, in dem die Planetenräder 16 abwälzbar sind. Im Bereich der Hauptdrehachse 15 ist ein doppelwandiges Rohr 60 angeordnet, das sich in Axialrichtung 43 durch das Planetengetriebe 10 erstreckt und als sogenanntes Pitch-Rohr dient. Das doppelwandige Rohr 60 umfasst ein äußeres Rohr 62 und ein inneres Rohr 64, zwischen denen ein Ringkanal 65 ausgebildet ist, durch den im Betrieb ein Schmierstoff 35 gefördert wird. Der Schmierstoff 35 ist Getriebekomponenten 11 zuzuführen um einen dauerhaft verschleißarmen Betrieb zu gewährleisten. Das äußere Rohr 62 verfügt dazu über eine Auslassstelle 63, die ein Austreten des Schmierstoffs 35 im Wesentlichen in eine äußere Radialrichtung 47 erlaubt. Die Auslassstelle 63 ist in einem mittleren Abschnitt 50 des doppelwandigen Rohr 60 positioniert, in dem die erste Planetenstufe 20 an die zweite Planetenstufe 30 grenzt.

Im Bereich der Auslassstelle 63 ist eine Lagerbuchse 40 angeordnet, die drehfest mit dem äußeren Rohr 62, und damit dem doppelwandigen Rohr 60, verbunden ist. Die Lagerbuchse 40 verfügt über eine Lagerbuchsenöffnung 41, die einen Durchtritt des Schmierstoffs 35 gewährleistet. Die Lagerbuchse 40 ist ferner in einem Führungslager 45 drehbar aufgenommen, das wiederum an der umgebenden Getriebekomponente 11, also dem Planetenträger 14 der zweiten Planetenstufe 30, angebracht ist. Der Planetenträger 14 der zweiten Planetenstufe 30 dreht sich wie das doppelwandige Rohr 60 im Betrieb um die Hauptdrehachse 15. Zwischen dem doppelwandigen Rohr 60 und der Getriebekomponente 11, an der das Führungslager 45 angeordnet ist, liegt im Betrieb eine Relativdrehung vor, der das Führungslager 45 folgt. An einer Außenfläche 42 der Lagerbuchse 40 ist eine Buchse 66 drehfest angeordnet, die korrespondierend zur Lagerbuchse 40 dazu ausgebildet ist, einen Durchtritt von Schmierstoff 35 zur Getriebekomponente 11 zu erlauben. Zwischen der Buchse 66 und der Getriebekomponente 11, in der das Führungslager 45 angeordnet ist, also dem Planetenträger 14 der zweiten Planetenstufe 30, ist ein Spalt 80 ausgebildet. Zwischen einer Außenfläche 67 der Buchse 66 und dem Planetenträger 14 der zweiten Planetenstufe 30 liegt daher kein unmittelbarer Kontakt vor. Der Spalt 80 ist derart dimensioniert, dass ein Verlust von Schmierstoff 35 dort minimiert ist. Die Getriebekomponente 11 ist mit einer Mehrzahl an Schmierstoffkanälen 22 versehen, die hydraulisch mit dem Spalt 80, der Buchse 66, der Lagerbuchse 40 und dem Ringkanal 65 im doppelwandigen Rohr 60 gekoppelt sind. Über die Schmierstoffkanäle 22 ist Schmierstoff 35 zu weiteren Getriebekomponenten 11, beispielsweise Planetenrädern 16, zur Schmierung und/oder Kühlung leitbar.

Durch das Führungslager 45 wird die Lagerbuchse 40 in Bezug auf die Getriebekomponente 11, also den Planetenträger 14 der zweiten Planetenstufe 30, in eine äußere und innere Radialrichtung 47, 49 geführt, wodurch der Spalt 80 eingestellt wird. Die Lagerbuchse 40 ist im Bereich des Führungslager 45 in einfacher Weise anpassbar, so dass Führungslager 45 im Wesentlichen unabhängig von Abmessungen des doppelwandigen Rohrs 60 auswählbar ist. Folglich ist für das Planetengetriebes 10 ein optimiertes Führungslager 45 auswählbar, das für den Spalt 80 reduzierte Schmierstoffverluste gewährleistet. Das Planetengetriebe 10 ist ferner in einem nicht näher gezeigten Computerprogrammprodukt 70 abgebildet, das zur Simulation des Planetengetriebes 10 ausgebildet ist.

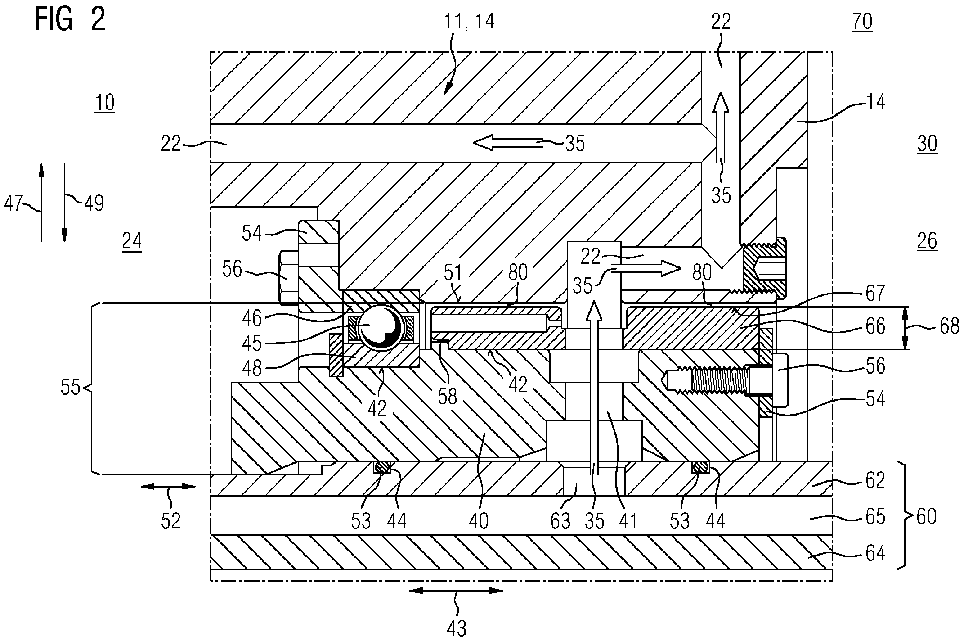

Die Ausführungsform gemäß FIG 1 ist in FIG 2 in einer Detailskizze näher dargestellt. FIG 1 und FIG 2 sind dementsprechend in gegenseitiger Ergänzung zu lesen. Am äußeren Rohr 62 des doppelwandigen Rohrs 60 sind Nuten 44 ausgebildet, in denen Dichtungselemente 53 angeordnet sind, die als O-Ringe ausgebildet sind. Über die Dichtungselemente 53 wird zwischen der Lagerbuchse 40 und dem doppelwandigen Rohr 60 eine Dichtung erzielt, die die einen Austritt von Schmierstoff 35 im Wesentlichen verhindert. Die Dichtungselemente 53 erlauben einen Axialversatz 52 zwischen der Lagerbuchse 40 und dem doppelwandigen Rohr 60. Dadurch wird eine mechanische Beanspruchung des Führungslagers 45 in Axialrichtung 43 reduziert, woraus eine erhöhte nutzbare Lebensdauer für das Führungslager 45 resultiert. Die Lagerbuchse 40 ist so ferner lösbar, also im Wesentlichen zerstörungsfrei lösbar, mit dem doppelwandigen Rohr 60 verbunden. Der Auslassstelle 63 des doppelwandigen Rohr 60 gegenüberliegend ist eine Lagerbuchsenöffnung 41 ausgebildet, den Durchtritt von Schmierstoff 35 aus dem Ringkanal 65 im doppelwandigen Rohr 60 in eine äußere Radialrichtung 47 ermöglicht. An der Außenfläche 42 der Lagerbuchse 40 ist die Buchse 66 angeordnet, die aus einem Gleitwerkstoff, beispielsweise Bronze, hergestellt sein kann. Die Buchse 66 ist durch die Lagerbuchse 40 im Wesentlichen unabhängig von Abmessungen des doppelwandigen Rohrs 60 konstruktiv auslegbar. Die Buchse 66 ist insbesondere lediglich auf die Erfordernisse des Spalts 80 zwischen dieser und einer Innenfläche 51 der Getriebekomponente 11 auslegbar, an der das Führungslager 45 angeordnet ist. Infolgedessen weist die Buchse 66 eine reduzierte Wandstärke 68 auf. Die Buchse 66 ist lösbar auf einer Außenfläche 42 der Lagerbuchse 40 angeordnet und formschlüssig durch einen Anschlag 58 und ein Halteelement 54 mit einem Befestigungsmittel 56 auf der Lagerbuchse 40 positioniert. Der Spalt 80 zwischen der Außenfläche 67 der Buchse 66 und der Getriebekomponente 11, also dem Planetenträger 14 der zweiten Planetenstufe 30, wird durch das Führungslager 45 eingestellt, das benachbart zur Buchse 66 angeordnet ist. Das Führungslager 45 umfasst einen Außenring 46, der an der Getriebekomponente 11 anliegt und einen Innenring 48, der an der Lagerbuchse 40 anliegt und so eine Relativdrehung zwischen der Lagerbuchse 40 und der Getriebekomponente 11 erlaubt. Die Außenfläche 42 der Lagerbuchse 40 ist benachbart zur Buchse 66 derart dimensionierbar, dass das Führungslager 45 im Wesentlichen unabhängig auswählbar ist. Dementsprechend ist das Führungslager 45 optimiert ausgewählt, so dass der Schmierstoffverlust am Spalt 80 minimiert ist. Das Führungslager 45 ist durch ein Halteelement 54 mit einem Befestigungsmittel 56 positioniert und ist infolgedessen lösbar, also im Wesentlichen zerstörungsfrei lösbar, mit der Getriebekomponente 11 verbunden. Das Halteelement 54 dient darüber hinaus als Verdrehsicherung. Dadurch ist das Führungslager 45 in einfacher Weise demontierbar. Die Lagerbuchse 40 und die Buchse 66 gehören zu einem Schmierstoffübergabemodul 55, das auch als solches austauschbar ist. Die Wartung des Planetengetriebes 10 ist daher weiter vereinfacht. Das Betriebsverhalten des Planetengetriebes 10, insbesondere ein Fließverhalten des Schmierstoffs 35 im Bereich der Lagerbuchse 40 und/oder der Buchse 66, und/oder ein Axialversatz 52 zwischen dem doppelwandigen Rohr 60 und der Getriebekomponente 11, ist durch ein nicht näher gezeigtes Computerprogrammprodukt 70 simulierbar.

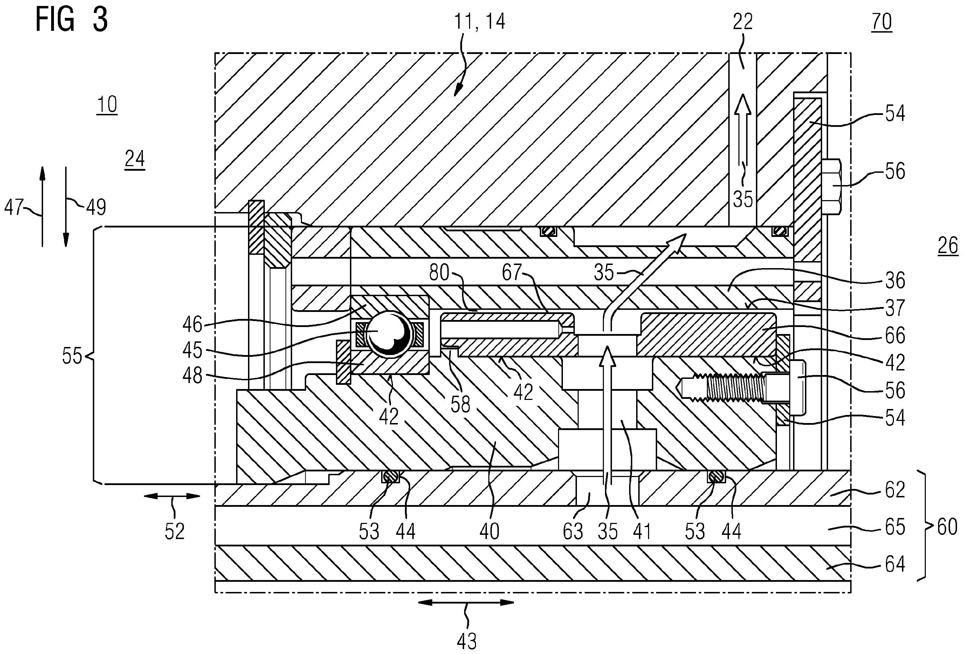

Eine zweite Ausführungsform des beanspruchten Planetengetriebes 10 ist in einer Detailansicht in FIG 3 im Längsschnitt dargestellt. Darin ist am äußeren Rohr 62 des doppelwandigen Rohr 60 eine Lagerbuchse 40 angeordnet, die drehfest mit dem doppelwandigen Rohr 60 verbunden ist. Am äußeren Rohr 62 sind Nuten 44 ausgebildet, in denen Dichtungselemente 53 angeordnet sind, die als O-Ringe ausgebildet sind. Dadurch wird ein Axialversatz 52 zwischen dem doppelwandigen Rohr 60 und der Lagerbuchse 40 erlaubt. In der Lagerbuchse 40 ist eine Lagerbuchsenöffnung 41 ausgebildet, die einen Durchtritt von Schmierstoff 35 aus dem Ringkanal 65 im doppelwandigen Rohr 60 in die Getriebekomponente 11 erlaubt. Auf einer Außenfläche 42 der Lagerbuchse 40 ist eine Buchse 66 angeordnet, die aus einem Gleitwerkstoff, beispielsweise Bronze, hergestellt sein kann. Benachbart zur Buchse 66 ist das Führungslager 45 angeordnet, das einen Außenring 46 und einen Innenring 48 umfasst. Der Außenring 46 des Führungslagers 45 ist an einer Gegenbuchse 36 angeordnet, die eine Innenfläche 37 aufweist, die einer Außenfläche 67 der Buchse 66 gegenüberliegend positioniert ist. Durch die Innenfläche 37 der Gegenbuchse 36 und die Außenfläche 67 der Buchse 66 ist ein Spalt 80 definiert, der durch das Führungslager 45 eingestellt ist. Der Spalt 80 ist derart ausgebildet, dass ein Schmierstoffverlust am Spalt 80 minimiert ist. Die Buchse 66 ist drehfest mit der Lagerbuchse 40 verbunden und folgt dementsprechend einer Drehung des doppelwandigen Rohrs 60. Die Gegenbuchse 36 ist drehfest mit der Getriebekomponente 11, also dem Planetenträger 14 der zweiten Planetenstufe 30, drehfest verbunden. Dementsprechend liegt im Betrieb des Planetengetriebes 10 am Spalt 80 eine Relativdrehung zwischen der Buchse 66 und der Gegenbuchse 36 vor. Die Buchse 66 ist über einen Anschlag 58 an der Lagerbuchse 40 und ein Halteelement 54 mit einem Befestigungsmittel 56 lösbar positioniert. Analog dazu ist die Gegenbuchse 36 über ein Halteelement 54 mit einem Befestigungsmittel 56 mit der Getriebekomponente 11 lösbar verbunden. Die Gegenbuchse 36 ist ferner zu einem weiteren Durchtritt des Schmierstoffs 35 ausgebildet, so dass Schmierstoff 35 über einen Schmierstoffkanal 22 in der Getriebekomponente 11 weiterleitbar ist. Die Lagerbuchse 40 mit der Buchse 66 und der Gegenbuchse 66 bilden zusammen ein Schmierstoffübergabemodul 55, das in einfacher Weise austauschbar ist. Dementsprechend ist eine Wartung des Planetengetriebes 10 nach FIG 3 vereinfacht. Das Betriebsverhalten des Planetengetriebes 10 nach FIG 3 ist ferner durch ein nicht näher gezeigtes Computerprogrammprodukt 70 simulierbar.

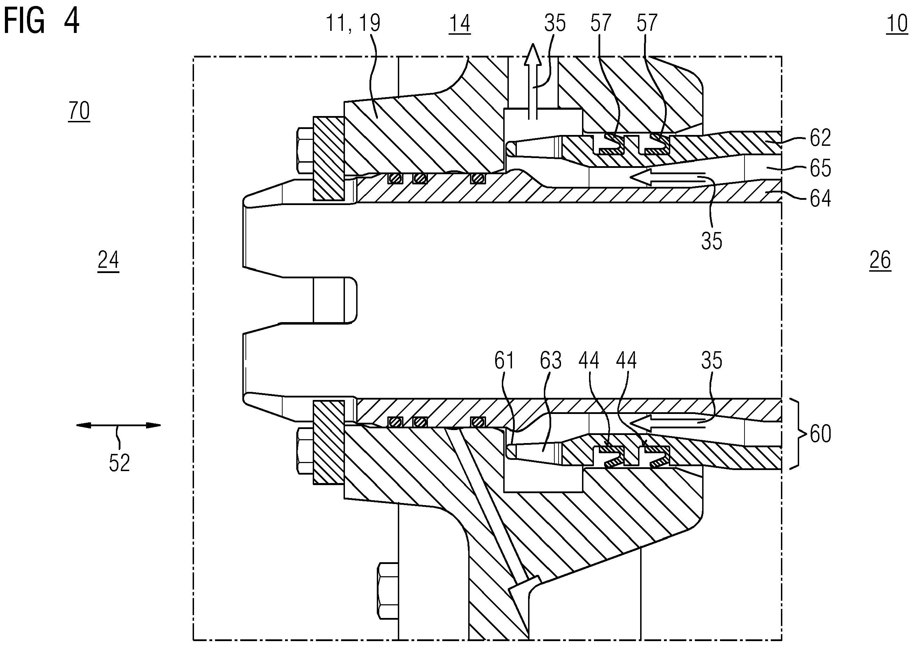

In FIG 4 ist schematisch eine dritte Ausführungsform des beanspruchten Planetengetriebes 10 in einer Detailansicht im Längsschnitt dargestellt. FIG 4 zeigt das doppelwandige Rohr 60 mit dem äußeren Rohr 62 und dem inneren Rohr 64 in einem Bereich eines ersten Endes 61, das einer Antriebsseite 24 zugewandt ist. Im Bereich des ersten Endes 61 ist das doppelwandige Rohr 60 mit einem Deckel 19 gekoppelt, der als Getriebekomponente 11 aufzufassen ist. Der Deckel 19 ist mit einem Planetenträger 14 einer ersten Planetenstufe 20 verbunden. Das äußerer Rohr 62 verfügt im Bereich des ersten Endes 61 über eine Auslassstelle 63, über die Schmierstoff 35 in den Deckel 19 abgebbar ist. Benachbart zur Auslassstelle 63 sind am äußeren Rohr 62 Nuten 44 ausgebildet, in denen Nutringe 57 angeordnet sind. Durch die Nutringe 57 wird eine Dichtung zwischen dem Deckel 19 und dem äußeren Rohr 62 des doppelwandigen Rohrs 60 hergestellt. Die Nutringe 57 sind ferner dazu ausgebildet, einen Axialversatz 52 und/oder einen Radialversatz zwischen dem äußeren Rohr 62 und dem Deckel 19 zu erlauben. Dadurch wird eine mechanische Beanspruchung eines nicht näher gezeigten Führungslagers 45 im Betrieb des Planetengetriebes 10 reduziert. Dadurch werden die technischen Vorteile des beanspruchten Planetengetriebes 10 in erhöhtem Umfang verwirklicht. Das Verhalten des äußeren Rohrs 62, insbesondere der sich daran einstellende Axialversatz 52, gehört zum Betriebsverhalten des Planetengetriebes 10, das durch ein nicht weiter abgebildetes Computerprogrammprodukt 70 simulierbar ist.

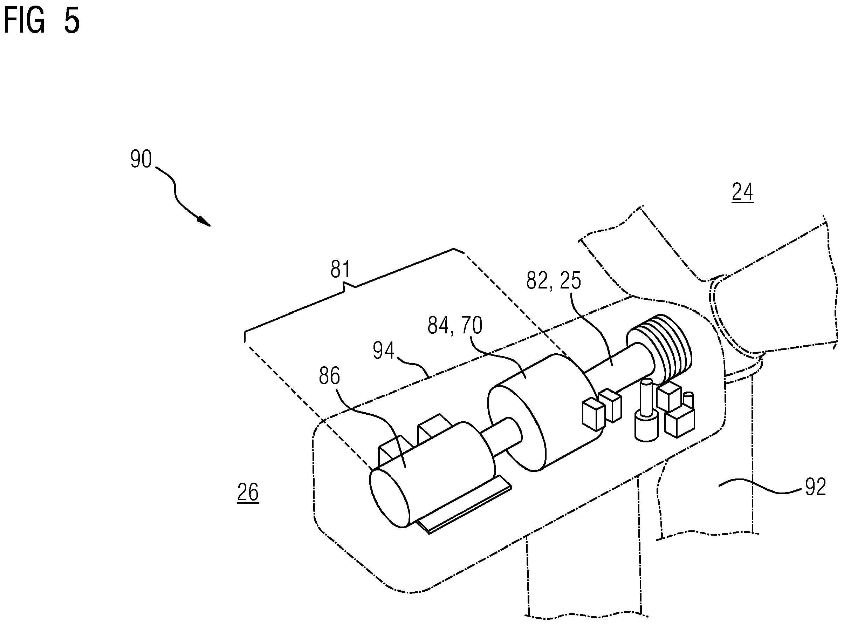

Eine Ausführungsform einer beanspruchten Windkraftanlage 90 ist in FIG 5 schematisch in einer geschnittenen Schrägansicht abgebildet. Die Windkraftanlage 90 umfasst eine Gondel 94, an der drehbar ein Mehrblattrotor 92 angebracht ist, durch den eine Antriebsleistung 25 bereitstellbar ist. Der Mehrblattrotor 92 ist auf einer Antriebsseite 24 angeordnet und mit einer Hauptwelle 82 verbunden, über die die Antriebsleistung 25 einem Antriebsstrang 81 zugeführt wird, der in der Gondel 94 aufgenommen ist. Der Antriebsstrang 81 umfasst neben der Hauptwelle 82 ein Getriebe 84, die drehmomentübertragend miteinander verbunden sind. Das Getriebe 84 ist drehmomentübertragend mit einem Generator 86 auf einer Abtriebsseite 26 verbunden. Das Getriebe 84 weist eine erste und eine zweite Planetenstufe 20, 30 auf und ist als Planetengetriebe 10 nach einer der oben skizzierten Ausführungsformen ausgebildet. Ferner ist das Planetengetriebe 10 in einem Computerprogrammprodukt 70 abgebildet, das dazu ausgebildet ist, den Betrieb des Planetengetriebes 10 in der Windkraftanlage 90 zu simulieren.

## Patentansprüche

1. Planetengetriebe (10), umfassend eine erste und eine zweite Planetenstufe (20, 30), zumindest eine Getriebekomponente (11) und ein doppelwandiges Rohr (60), an dem in einem mittleren Abschnitt (50) eine Auslassstelle (63) zum Abgeben von Schmierstoff (35) in die Getriebekomponente (11) ausgebildet ist, und das in einem Führungslager (45) aufgenommen ist, wobei im Bereich der Auslassstelle (63) eine Buchse (66) angeordnet ist, **dadurch gekennzeichnet, dass** zwischen der Buchse (66) und der Getriebekomponente (11) ein Spalt (80) ausgebildet ist.

2. Planetengetriebe (10) nach Anspruch 1, **dadurch gekennzeichnet, dass** der Spalt (80) an einer Außenfläche (67) der Buchse (66) ausgebildet ist.

3. Planetengetriebe (10) nach Anspruch 1 oder 2, **dadurch gekennzeichnet, dass** an einem äußeren Rohr (62) des doppelwandigen Rohrs (60) eine Lagerbuchse (40) angeordnet ist,

4. Planetengetriebe (10) nach Anspruch 3 **dadurch gekennzeichnet, dass** die Lagerbuchse (40) in einem Innenring (48) des Führungslagers (45) aufgenommen ist.

5. Planetengetriebe (10) nach Anspruch 3 oder 4, **dadurch gekennzeichnet, dass** die Buchse (66) auf der Lagerbuchse (40) angebracht ist.

6. Planetengetriebe (10) nach einem der Ansprüche 1 bis 5, **dadurch gekennzeichnet, dass** an der Getriebekomponente (11) eine Gegenbuchse (36) angeordnet ist, wobei zwischen der Gegenbuchse (36) und der Buchse (66) der Spalt (80) ausgebildet ist.

7. Planetengetriebe (10) nach einem der Ansprüche 1 bis 6, **dadurch gekennzeichnet, dass** die erste Planetenstufe (20) zumindest fünf Planetenräder (14) aufweist und/oder die zweite Planetenstufe (30) zumindest vier Planetenräder (14) aufweist.

8. Planetengetriebe (10) nach einem der Ansprüche 1 bis 7, **dadurch gekennzeichnet, dass** die zweite Planetenstufe (30) zwischen der ersten und einer dritten Planetenstufe (20, 39) angeordnet ist.

9. Planetengetriebe (10) nach einem der Ansprüche 1 bis 8, **dadurch gekennzeichnet, dass** die Getriebekomponente (11), an die der Schmierstoff (35) abzugeben ist, ein Planetenträger (14) ist.

10. Planetengetriebe (10) nach einem der Ansprüche 1 bis 9, **dadurch gekennzeichnet, dass** in einem Bereich eines ersten Endes (61) des doppelwandigen Rohrs (60) eine weitere Auslassstelle (63) ausgebildet ist, die über zumindest einen Nutring (57) abgedichtet ist.

11. Antriebsstrang (81) für eine Windkraftanlage (100), umfassend eine Hauptwelle (82), die drehmomentübertragend mit einem Getriebe (84) verbunden ist, das drehmomentübertragend mit einem Generator (86) verbunden ist, **dadurch gekennzeichnet, dass** das Getriebe (84) als Planetengetriebe (10) nach einem der Ansprüche 1 bis 10 ausgebildet ist.

12. Windkraftanlage (90), umfassend einen Mehrblattrotor (92), der drehbar an einer Gondel (97) angebracht ist, in der ein Antriebsstrang (81) aufgenommen ist, **dadurch gekennzeichnet, dass** der Antriebsstrang (91) nach Anspruch 11 ausgebildet ist.

13. Computerprogrammprodukt (70), das zur Simulation eines Betriebsverhaltens eines Planetengetriebes (10) ausgebildet ist, das in einem Antriebsstrang (81) einer Windkraftanlage (90) eingesetzt ist, **dadurch gekennzeichnet, dass** das Planetengetriebe (10) nach einem der Ansprüche 1 bis 10 ausgebildet ist.
